# EUROPEAN PATENT SPECIFICATION

(11) **EP 0 903 424 B1**
(45) Date of publication and mention of the grant of the patent: **03.04.2002**
(21) Application number: 98117232.3
(22) Date of filing: 11.09.1998
(51) Int. Cl.: C23C 26/00

(54) **Corrosion resistance of high temperature alloys**
Korrosionsbeständigkeit von Hochtemperatur-Legierungen
Résistance à la corrosion d'alliages résistant aux températures élevées

(30) Priority: 19.09.1997 US 59538 P
(43) Date of publication of application: 24.03.1999
(73) Proprietor: Haldor Topsoe A/S, 2800 Lyngby (DK)
(72) Inventor: Alstrup, Ib, 2840 Holte (DK); Chorkendorff, Ib, 3460 Birkerod (DK)
(74) Representative: Patentanwälte Zellentin & Partner

(56) References cited:
- WO-A-94/15896
- DE-A- 2 439 739
- DATABASE WPI Section Ch, Week 8122 Derwent Publications Ltd., London, GB; Class J08, AN 81-39357D XP002090077 & JP 56 018876 B (INOUE JAPAX RES INC) , 1 May 1981
- PATENT ABSTRACTS OF JAPAN vol. 010, no. 373 (C-391), 12 December 1986 & JP 61 166987 A (HITACHI CABLE LTD), 28 July 1986
- PATENT ABSTRACTS OF JAPAN vol. 010, no. 310 (C-379), 22 October 1986 & JP 61 119678 A (NIPPON STEEL CORP), 6 June 1986

## Description

The present invention relates to a method for protecting high temperature alloys containing iron, nickel and chromium against high temperature corrosion caused by carburization or metal dusting.

### Background of the Invention

It is a major problem in many industrial processes that the high temperature alloys commonly used as construction materials are susceptible to corrosion by oxidation or carburization or metal dusting when exposed at high temperatures to gases with a high carbon potential. Carburization is observed in the petrochemical industry, where ethylene is produced in pyrolysis furnaces by thermal cracking of hydrocarbons in a steam-hydrocarbon mixture at temperatures up to 1100°C. In this cracking process, coke deposition occurs at the inner walls of the cracking tubes. In steam reformers, natural gas or other hydrocarbons are converted by catalytic reaction on nickel catalysts to CO and H₂. Carburization of the tube walls is observed after overheating or excessive carbon activities. In industrial furnaces for heat treatment or carburization of steels, carburization of the carrying grates and of the furnace walls also occurs. Components of the CO₂-cooled nuclear reactor may be carburized by CO₂, and the heat exchangers of the helium-cooled reactor may be carburized by impurities such as CO and CH₄ in the helium. In coal gasification and in waste incineration plants, carburization is possible but the sulphidation and corrosion by chlorine will be more severe. Downstream of the steam reforming furnace, the heat recovering equipment is potentially vulnerable to a severe form of corrosion known as 'metal dusting'. It is a catastrophic carburization process to which alloys containing iron, nickel and cobalt is vulnerable, which results in the disintegration of the alloy into contrast to the above mentioned carburization, metal dusting occurs at temperatures as low as approximately 450°C. As a result of many studies, it has been concluded that virtually all available high temperature alloys are vulnerable to metal dusting. It has been shown that addition of H₂S to the gas may provide some resistance towards carburization and metal dusting. However, because of the risk of undesirable effects, such as catalysts poisoning, this cannot be used in many cases. Efficient means, generally applicable, for protecting such alloys against high temperature corrosion have until now not been developed.

Usually the protection of high temperature alloys against corrosion is dependent on the formation of an outer chromium-oxide layer. However, such an oxide layer may, under most practical conditions, not be protective for a very long time, because cracks can easily be formed in the oxide layer and spallation may occur due to loss of adherence to the underlying alloy. The same risks are present when a similar protection is attempted by coating the alloy surface with a protecting mixed oxide layer.

WO94/15896 discloses a process for hydrodealkylation in a reactor being treated with a carburization resistant composition in form of a film or coating applied for to the construction material.

The carburization resistant composition is preferably applied to the surface by means of anchoring to steel substrate through an intermediate carbide-rich bonding layer.

The resistant material is applied as surface coating by plating, cladding, in form of paints or other coating. The coatings are then cured under conditions to produce molten metals and/or compounds. The method of the present invention does not suffer from degradation of the protecting metal layer, because it does not depend on the formation of surface layers with thermal and mechanical properties being vastly different from those of the alloy.

### Summary of the Invention

In accordance with the present invention there is provided a method for protecting parts and components of industrial plants such as containers, tubes, ferrules, etc. made of high temperature alloys containing iron, nickel and chromium against corrosion by carburization or metal dusting. The method consists of: (a) cleaning of the alloy surface, (b) deposition of a thin layer of a noble or precious 0metal or of an element from group IV (i.e. Sn and Pb) or from group V (Sb and Bi) on the surface, and (c) heating of the surface in an inert atmosphere to a predetermined temperature period of time to obtain a uniform distribution of the noble or precious metal on and in the surface to be protected.

Deposition of the above metals may be carried out by conventional methods including physical or chemical vapour deposition or dipping, spraying or plating.

### Examples

The following examples serve to describe the manner of making and using the above mentioned invention in detail.

A number of metal dusting corrosion tests were carried out using as test samples cylindrical disks with a diameter of approximately 18 mm and thickness of 6 mm made of Alloy 800 H with following composition in wt%:
0.05-0.1 C, max. 1.0 Si, max. 1.5 Mn, max. 0.015 S, 30.0-35.0 Ni, 20.0 Cr, 45 Fe, 0.15-0.6 Ti, 0.15-0.6 Al, max. 0.75 Cu.

### Example 1

Test samples have been tested for metal dusting corrosion at the following conditions:

| | |
|---|---|
| Gas pressure | 34 bar |
| Gas composition | 49.3% H₂, 15.6% CO, 5.6% CO₂, 29.5% H₂O |
| Gas velocity | max. 10 m/s |
| Sample temperature | 650°C |
| Duration | 200 h |

Tests have been carried out after no surface treatment and after a number of different conventional pretreatments comprising polishing and cleaning of the surface, mechanical treatment, and oxidation of the surface. The mechanical treatments used are sandblasting and shot peening. In all these cases severe metal dusting attacks, i.e. carbon formation, pitting and loss of material were observed after a test. However, when the test sample was pretreated in accordance with the present invention no sign of corrosion could be seen on the pretreated surface after the above mentioned metal dusting corrosion test.

The following pretreatment was used: The surface was polished and cleaned. An approximately 1 µm thick gold layer was deposited by physical vapour deposition on the surface to be protected. Finally, the sample was kept at 900°C for 30 min. in a flow of helium.

### Example 2

An alloy 800 H test sample with the above mentioned composition has been tested at the following conditions:

| | |
|---|---|
| Gas pressure | 34 bar |
| Gas composition | 39.4% H₂, 37.2% CO, 1.7% CO₂, 21.7% H₂O |
| Gas velocity | max. 10 m/s |
| Sample temperature | 653°C |
| Duration | 100 h |

The following pretreatment was used before the test:

The sample surface was polished and cleaned. At approximately 3 µm thick tin layer was deposited electrochemically on the surface. The sample was kept at 800°C for 30 min. in a flow of helium.

No sign of corrosion could be seen on the pretreated surface after the metal dusting corrosion test.

## Claims

1. A method for enhancing the protection of high temperature alloy containing iron, nickel and chromium against high temperature corrosion by carburization or metal dusting consisting of:
(a) deposition of a thin layer of a metal selected from one or more of the noble metals, precious metals, metals from group IV and group V of the Periodic Table and mixtures thereof with a thickness in the range 0.01 to 10 µm on the surface to be protected; and
(b) annealing of the treated surface in an inert atmosphere to obtain a uniform distribution of the deposited metals on the surface of the high temperature alloy.

2. The method of claim 1, wherein the group IV metals are Sn and/or Pb.

3. The method of claim 1, wherein the group V metals are Sb and/or Bi.

## Patentansprüche

1. Verfahren zur Verstärkung des Schutzes von Eisen, Nickel und Chrom enthaltenden Hochtemperaturlegierungen gegen Hochtemperaturkorrosion durch Aufkohlung oder Metallstaubbildung, bestehend aus
a) Bildung eines Niederschlags einer dünnen Schicht eines Metalls, ausgewählt aus einem oder mehreren Edelmetallen, Metallen der Gruppe IV und der Gruppe V des Periodensystems und deren Mischungen mit einer Dicke im Bereich von 0,01 bis 10 µm auf der zu schützenden Oberfläche; und
b) Glühen der behandelten Oberfläche in einer inerten Atmosphäre, um eine einheitliche Verteilung der auf die Oberfläche der niedergeschlagenen Metalle zu erhalten.

2. Verfahren nach Anspruch 1, **dadurch gekennzeichnet, daß** die Metalle der Gruppe IV Sn und/oder Pb sind.

3. Verfahren nach Anspruch 1, **dadurch gekennzeichnet, daß** die Metalle der Gruppe V Sb und/oder Bi sind.

## Revendications

1. Procédé d'amélioration de la protection d'un alliage à haute température contenant du fer, du nickel ou du chrome vis-à-vis de la corrosion à haute température par carburation ou poussiérage métallique comprenant les étapes consistant à :
(a) déposer une couche mince d'un métal sélectionné parmi un ou plusieurs métaux nobles, un ou plusieurs métaux précieux, un ou plusieurs métaux issus du groupe IV ou du groupe V de la table périodique et leurs mélanges avec une épaisseur comprise entre 0,01 et 10 µm sur la surface à protéger; et
(b) recuire la surface traitée dans une atmosphère inerte pour obtenir une distribution uniforme des métaux déposés sur la surface de l'alliage à haute température.

2. Procédé selon la revendication 1, dans lequel les métaux du groupe IV sont le Sn et/ou le Pb.

3. Procédé selon la revendication 1, dans lequel les métaux du groupe V sont le Sb et/ou le Bi.
